# EUROPEAN PATENT APPLICATION

(11) **EP 0 664 558 A1**
(43) Date of publication of application: **26.07.1995**
(21) Application number: 93921119.9
(22) Date of filing: 05.10.1993
(51) Int. Cl.: H01L 21/304, H01L 21/302

(54) **METHOD FOR DRYING WAFER**

(30) Priority: 05.10.1992 JP 266384/92
(71) Applicant: OHMI, Tadahiro, Sendai-shi Miyagi-ken 980 (JP)
(72) Inventor: OHMI, Tadahiro, Sendai-shi Miyagi-ken 980 (JP)
(74) Representative: Weitzel, Wolfgang, Dr.-Ing. Patentanwalt
(86) International application number: JP9301432
(87) International publication number: WO9408354

(57) **Abstract**

A method of drying a wafer and performing perfect termination with hydrogen at the same time, by which a large number of wafers can be processed, the number of processings is decreased, and no contamination is caused. The method comprises the steps of mixing an inner gas and hydrogen gas to produce a mixed gas; producing hydrogen radicals by radicalizing hydrogen molecules contained in the mixed gas; introducing into a dry chamber a gas mixture containing hydrogen radicals; and drying wafers, cleaned by chemicals, by the gas mixture in the dry chamber and at the same time, terminating dangling bonds with hydrogen.

## Description

### Technical Field

The present invention relates to wafer drying. More specifically, it relates to a method for drying a wafer in which a process of drying a wafer, cleaned by chemicals, is carried out in a hydrogen radical atmosphere to terminate the surface of the wafer with the hydrogen.

### Background Art

As a process of terminating dangling bonds with hydrogen and a process of drying a wafer, cleaned by chemicals, the following techniques have been conventionally known.
(1) As a process of terminating dangling bonds with hydrogen, the process of introducing a wafer into a quartz pipe and heat-treating the wafer in a hydrogen atmosphere and at a high temperature of 600 °C or more.
(2) As a process of terminating dangling bonds with hydrogen, the process of cleaning a wafer with dilute hydrofluoric acid in the final cleaning step.
(3) As a process of terminating dangling bonds with hydrogen, the process of, after cleaning a wafer with dilute hydrofluoric acid, further cleaning the cleaned wafer with boiled ultra-pure water in a final cleaning step.
(4) As a process of drying a wafer, the process of blowing innert gas onto the surface of the wafer.
(5) As a process of drying a wafer, the process of turning the wafer and splashing chemicals thereon by centrifugal force.
(6) As a process of drying a wafer, the process of exposing the wafer to an isopropyl alcohol vapor atmosphere.

However, the above-described conventional techniques have the following problems.
(1) In the technique (1), the wafer is treated at a high temperature. Accordingly, it is contaminated and thermally affected.
(2) In the technique (2), the fluorine atoms remain on the surface of the wafer.
(3) In the technique (3), the wafer is contaminated by the device components.
(4) In the technique (5), the wafers are processed by leaf processing. Accordingly, the working efficiency is bad.
(5) In the technique (6), apparatuses for the exhaust and the drain are needed.
(6) In the techniques (1) to (6), drying a wafer and terminating a wafer with hydrogen cannot be carried out at the same time.

The object of the present invention is to provide a method for drying a wafer, in which drying a wafer and terminating the wafer with hydrogen can be carried out at the same time, a large number of wafers can be processed, the number of processing steps is decreased, no contamination is caused, and a perfect termination can be attained.

### Disclosure of the Invention

The present invention is characterized by comprising: the steps of mixing an innert gas and hydrogen gas to produce a mixed gas, producing hydrogen radicals by radicalizing hydrogen molecules contained in the mixed gas, introducing into a dry chamber the gas mixture containing hydrogen radicals, and drying wafers, cleaned by chemicals, with the gas mixture in the dry chamber and at the same time, terminating dangling bonds with hydrogen.

### Function

According to the present invention, since a hydrogen radical generating part is arranged upstream of a dry chamber, the wafer can be dried by a gas containing very active hydrogen radicals. Consequently, the drying of wafers, cleaned by chemicals, and the terminating of dangling bonds remaining on the wafers,can be performed at the same time. Further, according to the present invention, both the drying and the termination with hydrogen can be performed at a low temperature, whereby the problems of contamination of the wafers and the thermal effects thereon can be solved.

### Brief Description of the Drawings

Fig. 1 is a schematic view of an apparatus used in an embodiment of the present invention.

Fig. 2 is a spectrum in which the method of embodiment 1 and a conventional drying method using only nitrogen are compared using FT-IR.

Fig. 3 is a table describing cleaning of the Si wafers before drying according to the present embodiment.

Fig. 4 is a spectrum in which the method of embodiment 2 and a conventional drying method using only nitrogen are compared using FT-IR.

Fig. 5 is a schematic view of an apparatus used in embodiment 3 of the present invention.

Fig. 6 is a schematic view of an apparatus used in embodiment 4 of the present invention.

Fig. 7 is a spectrum in which the method of embodiment 4 and a conventional drying method using only nitrogen are compared using FT-IR.

### (Explanation of Reference Numerals)

101, 102 mass flow controller
103 heater
104 chamber for drying a wafer

### Best Mode for Carrying Out the Invention

The present invention will be hereinafter explained by embodiments.

### (Embodiment 1)

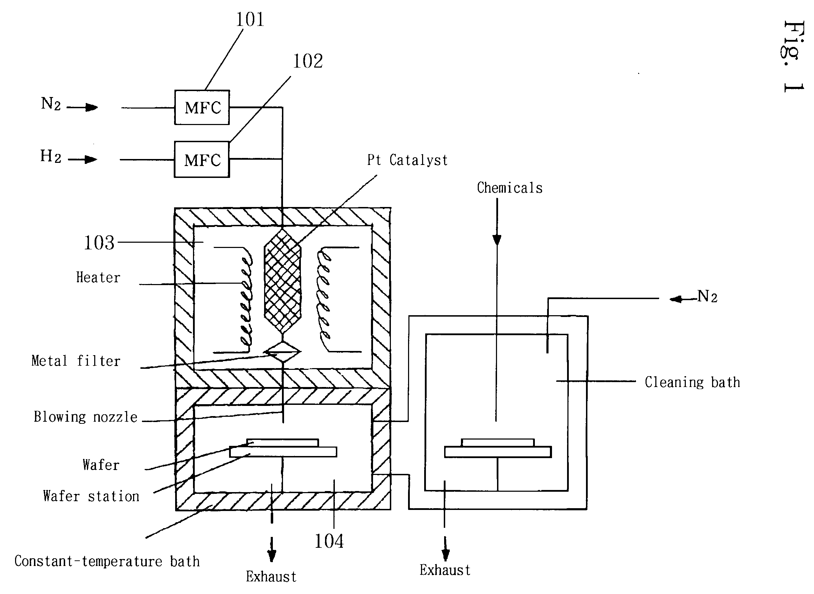

In the present embodiment, a process of drying a wafer, cleaned by chemicals (dilute hydrofluoric acid + ultra-pure water), and a process of terminating the surface of the wafer with hydrogen are carried out at the same time, by using a mixed gas of nitrogen and hydrogen. Fig. 1 is a schematic of an apparatus used in the present embodiment. As shown in Fig. 1, the nitrogen gas and the hydrogen gas were controlled by mass flow controllers 101 and 102 respectively and the respective gases were introduced into a heater 103 at flow volumes of 10L and 1L. Then, hydrogen radicals were generated in the heater 103 and the mixed gas of nitrogen and hydrogen, containing the hydrogen radicals, was blown on the wafer in the chamber 104 for drying a wafer. Very high purity gases were used in the mixed gas. Theá mixed gases contain 1ppb or less impurities. In this embodiment,a heater is composed of a vessel made of a stainless steel of SUS 316L. The vessel is filled with a platinum fiber. Theá temperature of the heater was maintained at 500 °C in this embodiment. An SUS 316L metal filter and a stainless pipe with a diameter of 1/4" were arranged downstream of the heater, so that gas was blown to the wafer from very near the surface thereof. The metal filter and the stainless steel pipe weremaintained at 500 °C. The temperature in the drying chamber was maintained at 100 °C. The drying chamber is connected to a cleaning bath through a gate valve, and the drying chamber and the cleaning bath are shut off from the outside air. Accordingly, the wafer can be processed from cleaning to drying without being exposed to the outside air. The drying period was 15 minutes in both the cleaning process and the drying process.

In this embodiment, drying was carried out using a hydrogen and nitrogen gas mixture having a hydrogen concentration of 10% and a flow volume of 11L. The hydrogen concentration is preferably 0.1% or more, and more preferably 1 to 10%. In this embodiment, the heater, the filter and the stainless pipe were maintained at 500 °C. However, other temperaturesá mayá beá used. For example, a temperature of 50 to 500 °C is preferable, a temperature of 200 to 500 °C is more preferable, and a temperature of 350 to 500 °C is most preferable. The material filling in the heater is not limited to the platinum, but any material may be used if the material is capable of generating hydrogená radicals at a temperature of 500 °C or less. However, a material which causes metal contamination is not preferable.á The diameter of the gas blowing nozzle is not limited to 1/4".

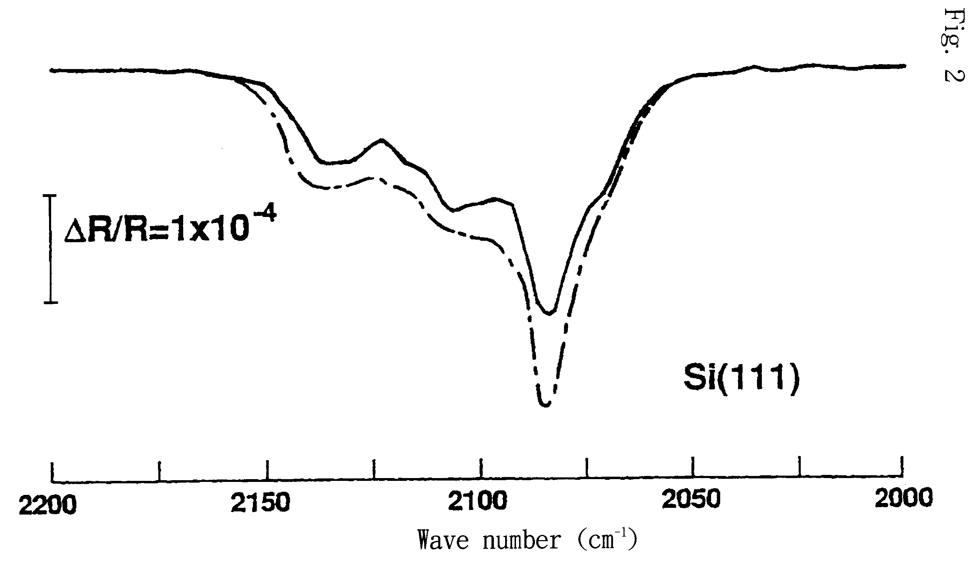

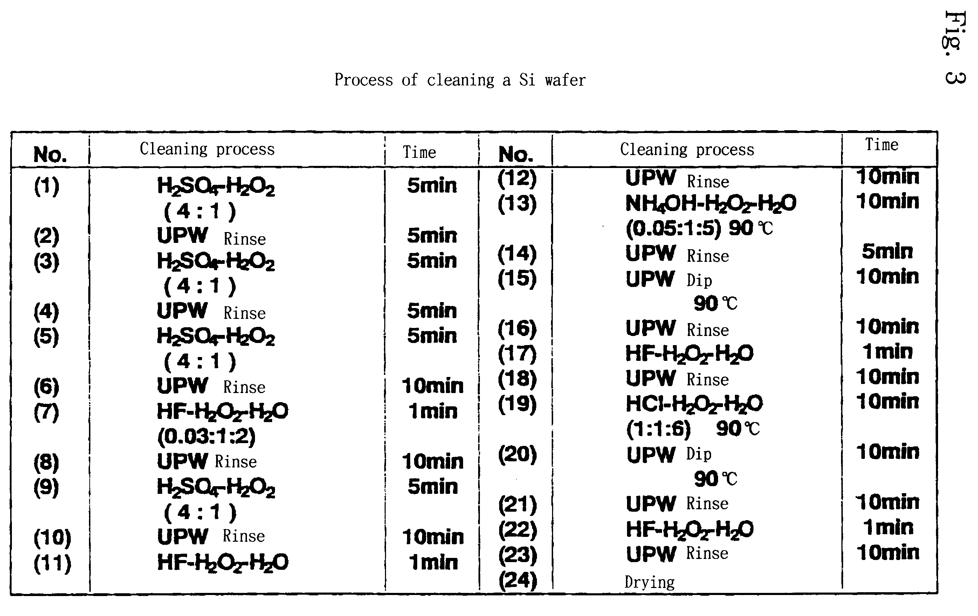

The method of the above-described embodiment and a conventional drying method using only nitrogen were comparatively evaluated by FT-IR. The evaluation result is shown in Fig. 2. In Fig. 2, the continuous line corresponds to the drying method of the embodiment and theá broken line corresponds to the conventional drying method using only nitrogen. The cleaning conditions by chemicals before the drying are shown in Fig. 3. As seen in Fig. 2, the drying method of the embodiment shows stronger infrared absorption corresponding to hydrogen terminated silicon than the conventinal method, thereby surely performing termination with hydrogen.

### (Embodiment 2)

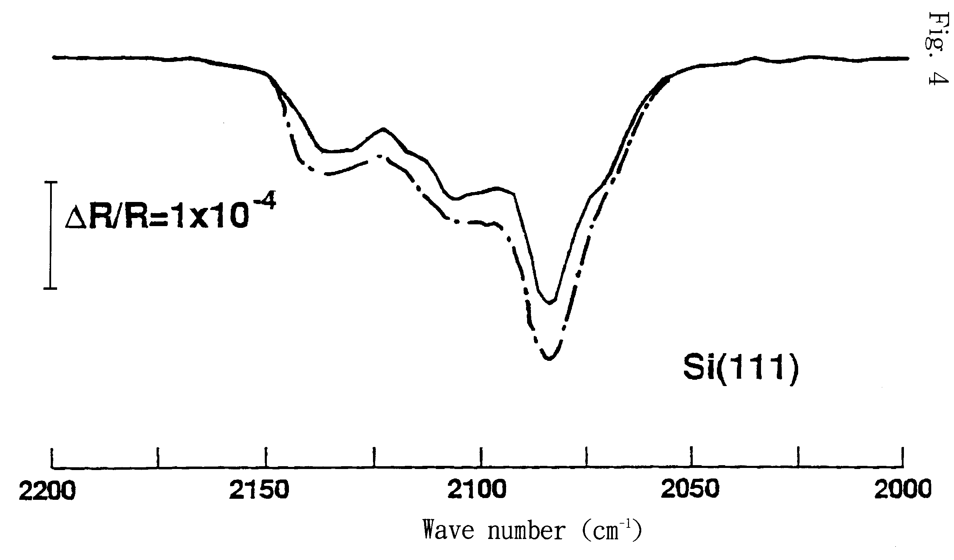

In the embodiment 2, a stainless steel fiber (SUS 316L) was used in place of the plutinum fiber filled in the heater in embodiment 1. Other conditions were the same as in the embodiment 1. In the embodiment 2, as can be found from Fig. 4, the drying method using a hydrogen and nitrogen mixed gas is stronger in the frared absorption of hydrogen-silicon than in the conventional method, thereby surely performing termination with hydrogen.

### (Embodiment 3)

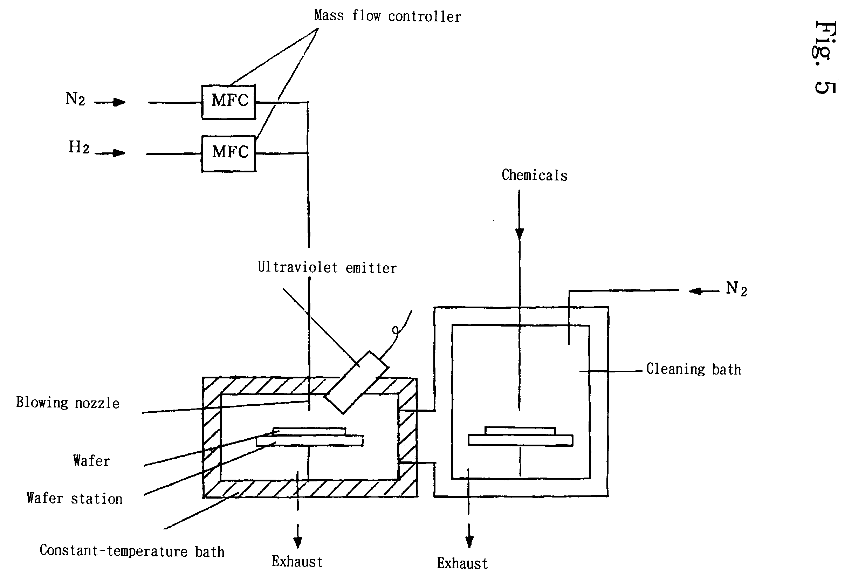

In embodiment 3, the hydrogen radical generation part arranged upstream of the drying chamber in embodiment 1 was removed, and instead, an ultraviolet irradiation mechanism was provided in the drying chamber. Then, hydrogen radicals were generated in the chamber so that both the wafer drying process after cleaning the wafer by chemicals (dilute hydrofluoric acide + ultra-pure water), and the process of terminating the surface of the wafer with hydrogen were performedá at the same time. Fig. 5 shows a schematic view of an apparatus used in embodiment 3. Other conditions were the same as in embodiment 1.

The same evaluations were carried out as in embodiment 1, and the same result as shown in Fig. 4 was obtained. Namely, in embodiment 3, the drying method using a hydrogen and nitrogen gas mixture shows stronger in frared absorption corresponding to hydrogen terminated silicon than the conventional method, thereby surely performing termination with hydrogen.

### (Embodiment 4)

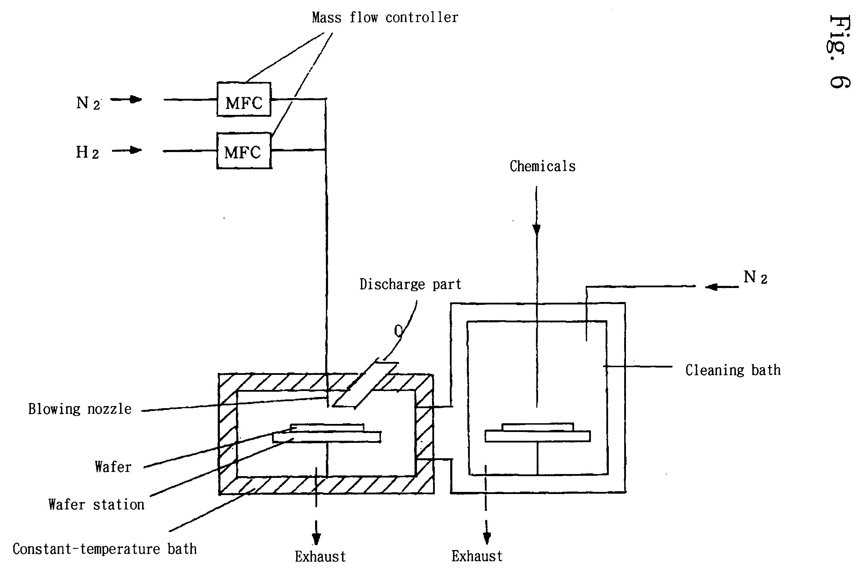

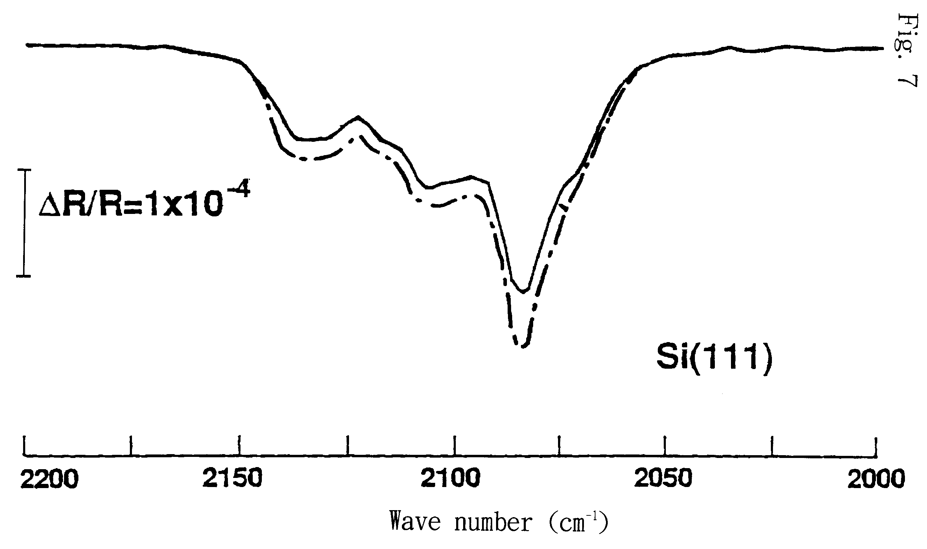

In embodiment 4, a hydrogen radical generation method usingá a discharge process at a high voltage was used instead of the hydrogen radical generation method usingáá the ultraviolet irradiation in embodiment 3. Other conditions were the same as in embodiment 1. Fig. 6 shows a schematic view of an apparatus used in embodiment 4. In the embodiment 4, as seen in Fig. 7, the drying method using a hydrogen and nitrogen gas mixture shows stronger in frared absorption corresponding to hydrogen terminated silicon than the conventional method, thereby surely performing termination with hydrogen.

### Industrial Applicability

As described above, according to claim 1, both drying a wafer, cleaned by chemicals, and terminating dangling bonds remaining on the wafer with hydrogen can be performed at the same time. Further, the drying and the termination with hydrogen can be performed at low temperature, whereby the problems of contamination of the wafer and the thermal effect thereon can be solved.

## Claims

1. A method for drying a wafer, characterized by comprising: the steps of mixing an innert gas and hydrogen gas to produce a mixed gas, producing hydrogen radicals by radicalizing hydrogen molecules contained in said mixed gas, introducing into a dry chamber the gas mixture containing hydrogen radicals, and drying wafers, cleaned by chemicals, with the gas mixture in the dry chamber and at the same time, terminating dangling bonds with hydrogen.

2. A method for drying a wafer according to claim 1, characterized in that the hydrogen radicals are produced by radicalizing hydrogen at a temperature of 50 to 500 °C in a heater, at least a part of the heater being composed of a material having a catalytic effect which causes hydrogen to radicalize at a low temperature.

3. A method for drying a wafer according to claim 1, characterized in that the gas mixture is introduced into a dry chamber without degrading the hydrogen radicals containingá the gas mixture as much as possible.

4. A method for drying a wafer according to claim 3, characterized in that in the gas mixture process, at least a part of the chamber is composed of a material having a catalytic effect which causes hydrogen to radicalize at a low temperature between the hydrogen radical production process and the drying process, and at least a part of the chamber can be heated to 50 to 500 °C, so that hydrogen radicals can be generated.

5. A method for drying a wafer according to claim 1, characterized in that in the drying process, the wafer cleaned bychemicals is dried and at the same time, the dangling bonds are terminated with hydrogen in the chamber, at least a part of which is composed of a material having a catalytic effect which causes hydrogen to radicalize at a low temperature,and at least a part of which can be heated to 50 to 500 °C.

6. A method for drying a wafer according to claim 1, characterized in that in the drying process, the wafer cleaned by the chemicals is dried and at the same time, theá dangling bonds are terminated with hydrogen in the dry chamber which is able to generate hydrogen radicals by irradiating the mixed gas of the hydrogen and the innert gas with energy such as ultraviolet, infrared, discharge or the like.
